Europäisches Patentamt

European Patent Office

Office européen des brevets

(11) Publication number: **0 460 337 A2**

# EUROPEAN PATENT APPLICATION

(21) Application number: **90630260.9**

(22) Date of filing: **21.12.90**

(51) Int. Cl.⁵: **H01J 37/16, H01J 37/32**

(30) Priority: **06.06.90 US 534672**

(43) Date of publication of application:
**11.12.91 Bulletin 91/50**

(84) Designated Contracting States:
**DE FR GB IT NL**

(71) Applicant: **BRANSON INTERNATIONAL PLASMA CORPORATION**
**31172 Huntwood Avenue**
**Hayward, California 94540-4136(US)**

(72) Inventor: **Nygren, Christopher Eugene**
**175 Elvira Street**
**Livermore, California 94550(US)**

(74) Representative: **Schmitz, Jean-Marie et al**
**OFFICE DENNEMEYER S.à.r.l. P.O. Box 1502**
**L-1015 Luxembourg(LU)**

(54) Plasma reactor and process with ceramic chamber.

(57) Plasma reactor and process which are particularly suitable for processing semiconductor wafers and the like with processes utilizing fluorinated chemistries. A workpiece is placed in a processing chamber, an ionized gas plasma is generated in a chamber having a wall fabricated of ceramic material which is not affected by fluorine, and the plasma from the generating chamber is introduced into the processing chamber.

EP 0 460 337 A2

This invention pertains generally to gas plasma reactors and, more particularly, to a plasma reactor and process which are particularly suitable for use with fluorinated chemistries.

Gas plasma reactors heretofore provided for use in the processing of semiconductor wafers and the like generally have chambers made of materials such as quartz or Pyrex glass. When processes utilizing fluorinated chemistries are carried out in such reactors, a problem exists in that the fluorine tends to erode the quartz or glass, resulting in particle contamination of the chamber walls and poor chamber lifetimes.

It is in general an object of the invention to provide a new an improved plasma reactor and process which are particularly suitable for use with fluorinated chemistries.

Another object of the invention is to provide a reactor and process of the above character which overcome the limitations and disadvantages of the reactors heretofore provided.

These and other objects are achieved in accordance with the invention by placing a workpiece in a processing chamber, generating an ionized gas plasma in a chamber having a wall fabricated of ceramic material which is not affected by fluorine, and introducing from the generating chamber into the processing chamber. In the disclosed embodiments, the chambers are aligned coaxially of each other, and the gas is introduced into the generating chamber through a dispersion tube which extends axially within the generating chamber.

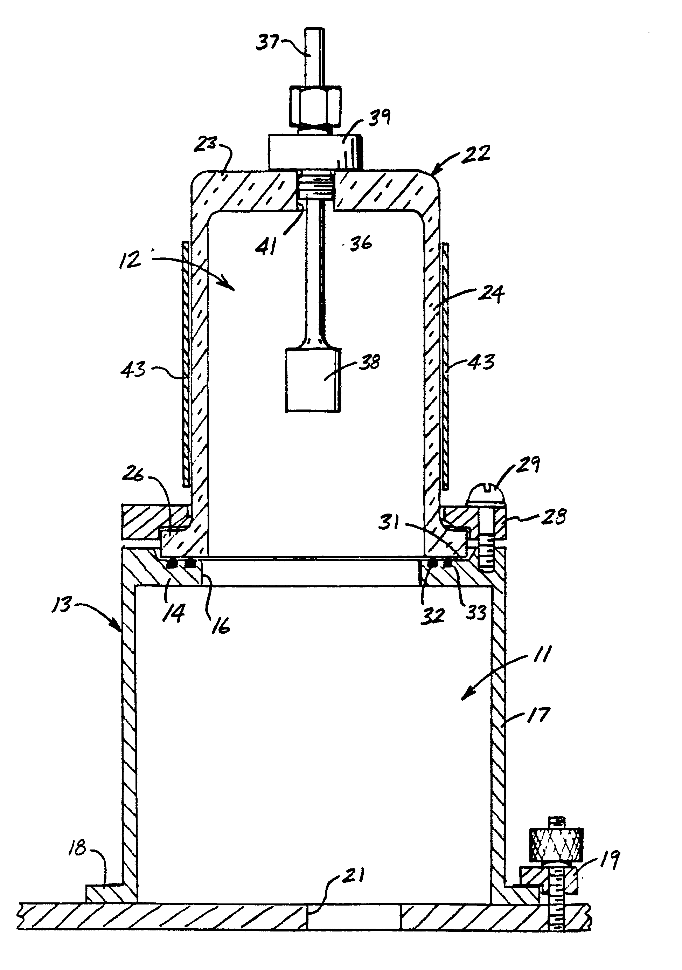

The single figure of drawing is a vertical sectional view of one embodiment of a reactor according to the invention.

As illustrated in the drawing, the reactor includes a processing chamber 11 and a plasma generating chamber 12. The processing chamber is formed within a housing 13 fabricated of aluminum or other suitable material and has an annular top wall 14 with a relatively large central opening 16, a cylindrical side wall 17, and an annular mounting flange 18 at the lower end of the side wall. The housing is mounted on a base plate and secured in place by a plurality of circumferentially spaced clamps 19 which engage the mounting flange. The base plate includes an exhaust port 21 through which gasses are removed from the chamber by a vacuum pump (not shown).

The generating chamber is positioned above the processing chamber and has a housing 22 with a top wall 23, a cylindrical side wall 24 and an annular flange 26 at the lower end of the side wall. This housing is fabricated of ceramic material which is not eroded or otherwise affected by fluorine, and in one presently preferred embodiment, it is fabricated of 99.5% pure ceramic. The two housings and the chambers formed therein are aligned axially of each other, with the central opening in the top wall of the processing chamber providing direct communication between the two chambers.

The two housings are clamped together by a retaining ring 28 which engages the upper side of flange 26 and by a plurality of circumferentially spaced screws 29 which extend between the retaining ring and the top wall of the lower chamber. The flange is received in a recess 31 in the top wall of the lower housing, and a pair of O-rings 32, 33 provide a tight seal between the two housings.

A gas dispersion tube 36 extends axially within the upper portion of the generating chamber. This tube has a stem portion 37 and a head portion 38, with the stem portion passing through a fitting 39 which is threadedly received in a central opening 41 in the top wall 23. The head portion is spaced below the top wall and is formed of a porous material through which gasses can diffuse into the chamber.

A source of gas (not shown) is connected to the dispersion tube outside the generating chamber. The type of gas is chosen in accordance with the process to be carried out, but the reactor is particularly suitable for use with fluorinated gases since they will not attach the walls of the chamber in which the plasma is generated.

A pair of electrodes 43 are clamped to the outside of chamber wall 24 and connected to a suitable RF generator for exciting the gas in the generating chamber to ionize the gas and form a plasma.

Operation and use of the reactor, and therein the method of the invention, are as follows. A wafer or other workpiece is placed in the processing chamber, and the two chambers are evacuated. Gas is then admitted into the upper chamber through the dispersion tube, and the electrodes are energized to for an ionized plasma in the upper chamber. This plasma flows into the lower chamber, and after exposure to the workpiece is exhausted through the exhaust port in the lower portion of the processing chamber.

Because the ceramic material which forms the walls of the generating chamber is not eroded or otherwise affected by fluorine and the electrodes which excite the gas are located outside the generating chamber, particle contamination is minimized. The generation of particles at the chamber walls is significantly reduced, and this substantially eliminates a major source of wafer contamination. The reactor has a longer life than reactors with chambers of quartz or other materials which are attacked by fluorine, and the elimination of particle contamination also results in more stable and repeatable process performance.

It is apparent from the foregoing that a new and improved plasma reactor and process have been provided. While only certain presently preferred embodiments have been described in detail, as will be apparent to those familiar with the art, certain changes and modifications can be made without departing from the scope of the invention as defined by the following claims.

## Claims

1. In a plasma reactor: a metallic housing defining a processing chamber for a workpiece, a ceramic housing defining a plasma generating chamber in communication with the processing chamber, means for introducing a gas into the plasma generating chamber, a pair of electrodes positioned outside the ceramic housing, and means for energizing the electrodes to ionize the gas and form a plasma in the plasma generating chamber.

2. The plasma reactor of Claim 1 wherein the metallic housing and the ceramic housing are positioned end-to-end and have cylindrical side walls disposed coaxially of each other, and the means for introducing the gas includes a dispersion tube which extends axially within the plasma generating chamber.

3. The plasma reactor of Claim 1 wherein the metallic housing is fabricated of aluminum.

4. In a plasma reactor: a processing chamber having a cylindrical side wall fabricated of metal, a plasma generating chamber having a cylindrical side wall fabricated of ceramic material positioned coaxially above the processing chamber with the two chambers in open communication with each other, means including an axially extending gas dispersion tube for introducing a gas into the plasma generating chamber, and means for ionizing the gas in the plasma generating chamber to form a plasma for processing a workpiece in the processing chamber.

5. The plasma reactor of Claim 4 wherein the means for ionizing the gas includes a pair of electrically energizable electrodes positioned outside the side wall of the plasma generating chamber.

6. In a plasma reactor: a processing chamber having a cylindrical side wall and an annular top wall with a relatively large central opening, a plasma generating chamber surmounted on the processing chamber and having a top wall and a cylindrical side wall fabricated of ceramic material with an annular flange at the lower end of the side wall in sealing engagement with the top wall of the processing chamber, a gas dispersion tube extending in axially through an opening in the top wall of the generating chamber for introducing gas into the generating chamber, and means for exciting the gas in the generating chamber to form an ionized plasma.

7. The plasma reactor of Claim 6 wherein the means for ionizing the gas includes a pair of electrically energizable electrodes positioned outside the side wall of the plasma generating chamber.

8. In a process for treatment of a workpiece in an ionized gas plasma utilizing a fluorinated chemistry, the steps of: placing the workpiece in a processing chamber, introducing a fluorinated gas into a plasma generating chamber positioned above the processing chamber and having a ceramic wall which is not affected by the fluorinated gas, exciting the gas to form an ionized plasma of the fluorinated gas in the generating chamber, and transferring the ionized plasma in a downward direction from the generating chamber to the processing chamber.

9. The process of Claim 6 wherein the fluorinated gas is introduced into the generating chamber though a gas dispersion tube which extends axially within the upper portion of the chamber.